(19) Europäisches Patentamt
European Patent Office
Office européen des brevets

(11) Publication number: **0 013 379**
**B1**

(12) **EUROPEAN PATENT SPECIFICATION**

(45) Date of publication of patent specification: **29.02.84**

(51) Int. Cl.$^3$: **H 01 B 3/48,** H 05 K 1/02

(21) Application number: **79105203.8**

(22) Date of filing: **17.12.79**

(54) **Dielectric material, circuit boards made from this material, and method of making said material and said circuit boards.**

(30) Priority: **26.12.78 US 972994**
**26.12.78 US 972995**

(43) Date of publication of application:
**23.07.80 Bulletin 80/15**

(45) Publication of the grant of the patent:
**29.02.84 Bulletin 84/9**

(84) Designated Contracting States:
**DE FR GB IT SE**

(56) References cited:
**FR - A - 1 387 586**
**US - A - 3 801 427**

(73) Proprietor: **ROGERS CORPORATION**
**Main Street**
**Rogers, Conn. 06263 (US)**

(72) Inventor: **Traut, Robert C.**
**Route 6A**
**South Killingly, Conn. 06239 (US)**

(74) Representative: **Meyers, Ernest et al,**
**c/o FREYLINGER & ASSOCIES Postfach 1153, 46 rue du Cimetière**
**Luxemburg (LU)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 013 379 B1**

Dielectric material, circuit boards made from this material, and method of making said material and said circuit boards.

The present invention relates to dielectric materials and a method by which such dielectric materials are made. The present invention also relates to circuit boards made from said material and a method by which such circuit boards are produced. Generally speaking, a circuit board such as a microwave circuit board comprises two conductive foils having inserted therebetween a material having a predetermined dielectric constant. The microwave circuit boards are then processed to remove portions of the conductive foil to define a circuit pattern. The removal of parts of the foil is usually accomplished by etchants, solvents, or the like.

One type of microwave circuit board was disclosed in a paper presented at IEEE/NEMA 1975 Electrical Electronics Insulation Conference at Boston, Massachusetts on November 11, 1975, "EPSILAM 10 A New High Dielectric Constant Conformable Copper Clad Laminate", M. Olyphant, Jr., D. D. Demeny, and T. E. Nowicki. EPSILAM 10, a product of the 3M Company, is believed to be a composite of poly(tetrafluoroethylene) (PTFE) and dielectric filler, the composite typically having a dielectric constant between 10 and 11 and being clad on both sides by copper foil.

In general, prior art microwave circuit boards exhibit numerous disadvantageous properties. For example, prior art microwave circuit boards, and more particularly the dielectric material from which these are made, tend to absorb moisture to an undesirable degree. Thus, when the conductive foil of the microwave circuit boards is removed by etchants or solvents, the underlying dielectric material absorbs moisture in undesirable amounts. The absorption of moisture results in at least two serious problems: the electrical properties of the circuit board are changed and the circuit board may physically expand, thus straining tolerances which must be observed in microwave circuit design.

The prior art circuit boards, when processed to remove portions of the conductive foil to define circuits, tend to undergo strain relief to an undesirable degree. Strain relief is a measurement which quantifies the dimensional changes in the microwave circuit board after it is processed to remove a portion of the conductive foil. As will be understood by those skilled in the art, it is undesirable to have a circuit board which changes in shape substantially when processed to remove a portion of the copper foil.

Moreover, prior art microwave circuit boards may tend to have a non-uniform dielectric constant throughout any one microwave circuit board. It is believed that this non-uniformity of dielectric constant is due, at least in part, to incomplete mixing of the dielectric filler with the PTFE. Thus, in certain portions of the circuit board, there may be an excess of PTFE and insufficient dielectric filler.

Furthermore, prior art microwave circuit boards may tend to have a relatively high energy dissipation factor.

Another type of microwave circuit board is that made by Rogers Corporation, Rogers, Connecticut, and marketed under the trademark RT/Duroid. This product, which comprises PTFE and glass micro-fibers, has the desired strain relief properties but does not have a sufficiently high dielectric constant for some applications.

From US—A—3 801 427 there is known a dielectric material comprising a polymer binder, an inorganic filler in particulate form and glass fibers, a method of making it and printed circuit boards produced therefrom.

The present invention as claimed is intended to provide a dielectric material which is moisture-resistant, which has a relatively high and uniform dielectric constant and which has a relatively low dissipation factor at high frequencies, as well as a circuit board made from said dielectric material. A related object of the invention is to provide a method of making said dielectric material and said circuit boards.

The dielectric material according to the invention comprises a composite of a fluorinated polymer binder, a ceramic filler having a high dielectric constant, and non-conductive inorganic microfibrous material having an average diameter of between 0.1 and 1 $\mu m$ and an average length of less than 3 mm, the amount of said microfibers being less than 10% by weight of the dielectric material. The dielectric material is produced by mixing a dispersion of polymer particles with particular filler material and microfibrous material to form a slurry of polymer particles, filler particles and fiber, agglomerating the polymer particles, the filler particles and the fibers to provide a mass, and shaping said mass to form a dielectric material.

The circuit board of the present invention comprises a sheet of dielectric material having a layer of conductive foil adhered to either side of the sheet. In the method of making the microwave circuit boards, the dielectric material is formed and the conductive foil is subsequently adhered to both sides of the dielectric material.

In the preferred embodiment of the invention, the polymer dispersion comprises an anionic dispersion of poly(tetrafluoroethylene), the particulate filler comprises titania and the microfibrous material comprises glass microfibers.

The circuit board of the present invention provides for reduced strain relief when the copper foil is removed by etchant or solvent. The microwave circuit board is also particularly

moisture resistant. In the microwave circuit board moisture resistance is a particularly important property because the electrical properties of the material will change if the circuit board absorbs moisture. Moreover, the microwave circuit board of the present invention has a relatively high dielectric constant which is uniform throughout the entire circuit board. The microwave circuit board also has a relatively low energy dissipation factor.

The microwave circuit board of the present invention comprises a sheet of dielectric material having conductive foil clad to one and usually both sides of the sheet. In the method of making the circuit boards, the dielectric material is produced and, subsequently, the conductive foil, a copper foil by way of example, is adhered to opposite sides of the sheet.

In the process of making the dielectric material, a dispersion of polymer particles is selected, the polymer being dispersed by ionic or non-ionic surfactants. It is desirable that the polymer have a melting point higher than about 300°C so that a circuit board made from the polymer is capable of withstanding high environmental and processing temperatures. The polymer may be selected from the following classes: Halogenated hydrocarbons such as poly(tetrafluoroethylene) (PTFE) and fluorinated poly(ethane-co-propene) and poly(vinylidene fluoride).

The polymer dispersion is preferably an aqueous dispersion which is diluted to between about 10 and about 35 weight percent solids, most preferably about twenty weight percent solids.

A dielectric filler is added to the polymer dispersion and mixed so as to uniformly distribute the filler in the dispersion. The filler can comprise from about ten weight percent to about sixty-five weight percent of the dielectric material. For a dielectric constant of 10.5 using nonpigmentary titania filler, the filler should comprise between about 60 and 65 weight percent of the dielectric material. The filler and the amount of the filler in the dielectric material is selected depending upon the desired electrical properties of the dielectric material. Although it should be understood that the dielectric filler can be selected from any of a number of known dielectric materials, exemplary materials include titania, alumina, zirconia, ground quartz, amorphous or crystalline silica, and ferrite ceramics in powder form. The upper limitation on the weight percent of the filler in the dielectric material is the amount at which the circuit board would exhibit undesirable porosity or impaired strength. The filler material should be used in particle form and the average particle size should be below about 50 micrometers, and, most preferably, between about 1 and 20 micrometers. The preferred filler material is titania. It should also be understood that a mixture of different filler materials may be used. For example, it may be desirable to use a titania filler and modify the magnetic permeability of the resulting circuit board by including ferrite fillers. The filler added may be a mixture of filler and liquid, thereby simplifying handling of the filler and providing intimate mixture of the filler with the polymer dispersion.

Microfibers are then added to the polymer and filler slurry and are mixed in the slurry to provide a slurry of polymer, filler, and microfibers. Although it is preferred that the fiber comprise microfibrous glass, the fiber could be made from other compositions, such as fibrous aluminum silicate, fibrous microcrystalline materials such as potassium titanate whisker material. Examples of other non-conductive microfibers include quartz fiber and zirconia fibers.

The fibers have an average diameter of between 0.1 and 1.0 micrometers. It is preferred that the fibers have, on the average, a relatively short length, preferably below about 3 millimeters. Since many of the fibers provided from conventional sources exceed these desired lengths, the fibers may be broken by any conventional mechanical means, such as grinding the fibers, or pressing the fibers to crush the fibers. The amount of microfibrous material included in the dielectric material should be sufficient to provide desired strain relief and rigidity. In general, it is preferred that the microfibers be added in an amount less than about 10 weight percent of the dielectric material. A particularly preferred source of fiber is a fiber sold by Johns Manville, under the designation 104E, a fiber believed to comprise a low sodium and potassium content borosilicate glass. The fibers may be added in dry form or may be added in a liquid-fiber slurry to facilitate handling.

It should be understood that the polymer, the filler material, and the fibers may be mixed in any order. However, it is desirable to mix the afore-mentioned materials in such a manner to provide uniform distribution of the materials. This is believed to be desirable in order to provide a dielectric material having a relatively uniform dielectric constant, uniform strain relief and uniform moisture resistance. Although it is envisioned that other liquids may be used in the slurry, it is particularly preferred that the aforementioned slurry have an aqueous base. Once the slurry is mixed in any conventional manner to a point wherein the fibers, the particles of filler material, and the polymer are intimately and uniformly mixed, the materials in the slurry are agglomerated to provide a dough-like mass.

In order to agglomerate the mixture of polymer, filler and fibers, a flocculant is added to the mixture. It should be understood that the chemical composition of the flocculant used is dependant upon the polymer chosen and the manner by which the polymer is dispersed.

The preferred flocculating agent for formulations based on PTFE is poly(ethyleneimine),

(PEI), a commercially available water soluble polymer having the repeating unit:

$$-\!\!\!\left[CH_2CH_2NH\right]\!\!\!-$$

and available as an aqueous solution. It is understood that aqueous solutions combine with $H_2O$ to form a polycationic material with the repeating unit:

$$-\left[\begin{array}{c} CH_2CH_2\overset{+}{N}H_2 \\ OH^- \end{array}\right]-$$

A large number of other polycationic flocculating agents could also be used. It is believed that these materials flocculate the mixture by attaching to anionic groups on the surfaces of the polymer particles, the fibers, and the fillers. Another type of flocculant that would be effective with ionically stabilized polymer dispersions is the use of hydrolyzable inorganic compounds that form aqueous solutions of polyvalent ions. These function by reducing the ionic double layer repulsion between polymer particles.

The liquid is then removed from the agglomerated mass by any given conventional means. A preferred method of removing the liquid from the agglomerated material is to transfer the agglomerated material to a nylon fabric filter bag and allow gravity drainage of the material. By this method there is produced a wet crumbly dough having about 60 weight percent solids. The batch may be then spread thinly in shallow trays and allowed to dry in an oven at a temperature of 100 to 200°C for 16 to 24 hours or at any temperature and time sufficient to remove the liquid from the agglomerated material.

The agglomerate or dough comprising the polymer, filler, and microfibers can be directly formed into a desired shape. In the case of an aqueous slurry, it should be understood that the forming of the agglomerate into sheets or other desired shapes is difficult because the agglomerate tends to be sticky and clog extrusion dyes or stick to calendering apparatus. In cases where it is difficult to form the desired shapes from the aqueous agglomerate, it is preferred that the agglomerate be dried and then mixed with a suitable lubricant, the lubricant allowing for forming of the agglomerate by any conventional means such as calendering or paste extrusion.

The lubricant can be selected from various conventional lubricants. It is particularly preferred that the lubricant be non-toxic as a liquid or a vapor and have a relatively low volatility so that at forming temperatures, the liquid lubricant will not vaporize. However, it should be understood that for particular forming methods, it may be necessary to use a toxic lubricant which may also have a relatively high volatility. The particularly preferred lubricant is dipropylene glycol (DPG) manufactured by Union Carbide Corporation. Other types of lubricants include Stoddard solvent, a mixture of aliphatic hydrocarbons commercially available as a dry cleaning fluid, a liquid polyisobutylene sold by Exxon under the Vistanex trademark and esters such as dioctylphthalate.

In the preferred embodiment of the invention, the polymer dispersion is an aqueous dispersion of PTFE particles stabilized by an added nonionic surface active agent. The filler material is a ceramic grade titanium dioxide and the fibers are borosilicate glass fibers, all of which are believed to have a negative charge.

A flocculating agent is added to the mixture to agglomerate the filler, the PTFE particles and the fibers. The water is removed from the agglomerate to provide a dried crumb dough.

The lubricant is mixed with the dried crumb dough so as to uniformly disperse the lubricant and to break up the large aggregates of the dough. The mixture of the lubricant and the dough provides a material which is still dry in appearance and in a crumb or fibrous particle form. The material may then be formed by conventional methods, such as, for example, paste extrusion and/or calendering. After the dough is formed into the desired shape, the formed shape, whether a sheet or some other shape, is dried in a vented forced air circulation oven for 16 to 24 hours at 200 to 300°C. The dried dielectric material may be cut or trimmed to desired dimensions. Subsequent to formation of the desired dielectric material, conductive plates or foil are adhered to the dielectric material. It is preferred that the conductive plates be made from copper foil having a thickness of between about 3 and about 68 micrometers, most preferably 34 micrometers. The formed sheets and the conductive plates are laminated together using heat and pressure to cause densification of the sheets and adhesion of the sheets to each other and to the conductive plates.

The above-described process of the present invention provides a unique microwave circuit board. The circuit boards provided by the present invention have various properties that make the microwave circuit board particularly useful.

One important aspect of the present invention is the provision of a microwave circuit board wherein strain relief is reduced. As mentioned earlier, strain relief is a measurement of the dimensional changes of the microwave circuit board after a portion of the conductive foil has been removed by an etchant or a solvent. As would be understood by one skilled in the art, it is highly desirable to reduce the dimensional changes of the circuit board because of the high tolerances within which these circuit boards are to be used.

Strain relief is measured by determining the dimensional change of a strip specimen due to removal of the conductive foil. Sometimes the

change in dimension is retarded by viscoelastic behavior of the composite. It has been found that a brief heat exposure after foil removal accelerates the change in dimension.

In the case of PTFE, titania and microfiber glass composites described as the preferred embodiment of this invention as well as other microwave circuit board materials based on PTFE, the following procedure for measuring strain relief is believed to be satisfactory:

1. A 25 millimeter strip of the material is cut, taking care to avoid flexing or other mishandling that would impose strains on the specimen.
2. Use of sharp stylus to mark two points on the metal foil, about 300 mm apart, on the same side of the specimen.
3. Condition the specimens for 24 hours in standard laboratory conditions, 23°C, 50% R.H.
4. Measure in the same atmosphere the distance between centers of the marks using an optical method capable of 5 micrometer resolution.
5. Mask an area encompassing each mark about 12 millimeters square using a pressure sensitive tape capable of withstanding etching conditions.
6. Chemically etch away the metal foil, except for the masked areas. This can be done with various etchants known to those versed in the art, such as solutions of ferric chloride or ammonium persulphate. Rinse the etched specimen in clean water.
7. Remove the masks.
8. Bake the specimen for one hour at 150°C followed by conditioning as in step 3.
9. Measure the distance between centers of the marks.
10. Calculate dimension change as mm change per meter of original length between marks.

Another important property of the circuit board provided by the present invention is that the circuit board is moisture-resistant. Moisture resistance is measured by weighing specimens of the dielectric material from which the metal foil has been removed by etching followed by washing and drying for 1 hour at 150°C. The weighing is done before and after a water immersion test and the amount of water absorbed is determined. Water immersion is for 48 hours at 50°C. It has been found that with the preferred embodiment of this invention, it is possible to fabricate circuit boards that absorb less than about 0.3 weight percent water when subjected to the afore-mentioned test.

A further important property of the circuit board provided by the method of the present invention is that a circuit board having a relatively high dielectric constant is provided, the dielectric constant being quite uniform throughout the entire circuit board. The dielectric constant is measured for a circuit board having a total thickness of between about 0.2 and 3.0 millimeters, the total thickness including two sheets of copper foil each having a thickness of about 34 micrometers. It has been found that with the described method, it is possible to provide a circuit board having a dielectric constant in the range of about 10 to about 11 and having a uniformity of $\pm.25$.

The dielectric constant is measured at microwave frequencies by employing adaptations of one of the test methods described in American Society of Testing and Materials Standard Methods D-3380 or D-2520. With these as background information we have found that an effective method involves etching two resonator elements of differing lengths with their appropriate probe lines onto a given specimen. The etched specimen together with a matching specimen etched free of foil are clamped between conductive plates to form an assembly containing two stripline resonators. The resonant frequencies in the 8 to 12.5 GHz range and the lengths of these resonators are determined at a clamping stress of 70 kg/cm$^2$. From these data one may then calculate the fringing correction for the resonator length and the dielectric constant. The calculation is based on the known fact that the propagation velocity of a transverse electrical mode electromagnetic wave through a dielectric medium having a magnetic permeability of unity is related directly to the square root of the inverse of the dielectric constant.

Another important property of the circuit board provided by the method of the present invention is that the circuit board has a relatively low energy dissipation factor at high frequencies. At 10 G Hertz, the circuit board usually has a dissipation factor of less than about .005. The dissipation factor is measured as follows:

The half power width of the resonant frequency peak in the stripline resonator method described before is divided by the resonant frequency to give a dissipation ratio for both metal and dielectric. An estimation value for the metal is calculated and subtracted from the ratio to give dissipation factor of the dielectric material.

Example 1

The ingredients were slurried as follows: 45 liters of tap water were placed in a 20-gallon tank and mixed with 148 grams of microfiber (Johns Manville's 104E glass fiber pre-crushed by rolling). The water and microfibers were mixed for about ten minutes. The filler containing 2520 grams of solids, a titania filler sold by National Lead Industries under the trademark Titanox 3030 was added and was mixed with the microfiber and water mixture for five minutes. A polymer dispersion of PTFE, believed prepared by emulsion polyminzation of TFE in the presence of a perfluoroalkane carboxy salt emulsifying agent and stabilized after polymerization by the addition of about 0.7% nonionic surface active agent poly(ethyleneoxy) nonyl phenol, sold by ICI under the trademark

Fluon AD-704 was added and was mixed for about 10 minutes. The level of water was brought up to 50 liters with additional water. The slurry was mixed for five minutes and then a flocculant was added. The flocculant used in this example was poly(ethyleneimine) (PEI) in a one-weight percent solution. Eighty grams of 1% solution was added to the slurry and the slurry was mixed for about 1/2 minutes. Additional flocculant solution was added in small increments until the flocculation resulted in clear water between the flocs. The total amount of flocculant solution added was about 120 grams.

The flocculated solids suspended in water were transferred to a nylon fabric filter bag to allow gravity drainage of the water, thereby providing a wet, crumbly dough having approximately 68% solids. The crumb was then spread in a one-inch thick layer in shallow trays and dried for 24 hours at 160°C in a forced air circulation oven. The dried crumb was in the form of small chunks. Thereafter, the dried crumb was mixed with a lubricant. The lubricant used was dipropylene glycol (DPG) sold by Union Carbide Corporation. DPG is non-toxic as a liquid or as a vapor and has a relatively low volatility at room temperature. A blender was used to mix the aggregates of dried crum and uniformly dispurse the lubricant. For 3,900 grams of crub, 688 grams of lubricant was added.

The lubricated dough was then formed into sheets. First, the lubricated dough was formed into a billet having dimensions 38 mm diameter by about 40 mm height. The billets were then extrusion-pressed at about 844 kg/cm² at a speed of about 76 mm per minute through a 4.8 mm diameter die to produce a ropelike extrudate of about 5 mm diameter. This was then passed through a 2 roll calender with a .25 mm gap setting to produce a ribbon. The X direction is considered parallel to the extrusion and the Y direction perpendicular to the X direction in the plane of the ribbon. These coordinates are discussed in connection with the finished clad panels.

Several layers of ribbon were combined in two calendering operations in the X direction and the spacing between the rollers of the calender was 1.14 mm and 0.889 mm respectively. The calender roll force against gap determining stops was set as 6.3 kg/cm² at the selected gap on the two 203 mm diameter cylinders of the calender. Sheets 325 mm long were cut from the extruded ribbon and were extended by repeated calendering passes in the Y direction to form sheets about 305 mm wide and at least 508 mm long.

The sheets were laid in a stack on clean, aluminum trays and dried in a vented forced air circulation oven for 24 hours at 246°C whereafter the sheets were trimmed accurately to an 280 by 457 mm sheet.

The sheets were clad with copper foil rolled to a thickness of about 34 micrometers and surface treated for adhesion on one side. The foil was cut to sheet size of 470 by 292 mm.

The composite sheets were stacked to attain the desired thickness and assembled between copper foil and stainless steel caul plates to form a layup or laminating package that was then wrapped in an aluminum foil envelope folded and rolled at the edges to exclude air. The package was clamped between cold platens in a laminating press at about 35 kg/cm². This pressure was maintained through a heating and cooling procedure that caused the composite to undergo crystalline melt and limited flow to accomplish densification and adhesion of the sheets to adjacent sheets or adjacent foil in the layup. The heating was done by electrical heating elements in the platens controlled thermostatically to maintain a package temperature of 396°C for 45 minutes. At the end of this period the heating circuits were turned off and the platens and package allowed to cool over an additional 3 to 4 hour period to a temperature below 150°C at which point the press was opened and the laminated panels were removed from between the plates.

The microwave circuit boards were tested for the various properties indicated in Table 1.

Example 2

A lubricated dough compound was prepared by exactly the same method as in example 1 except that a slight change was made in the proportion of polymer, fiber, and filler so that they were present in 62.8, 3.7 and 33.5 parts by weight respectively.

The lubricated dough was then molded into bricks having dimensions of 50 mm by 150 mm by 50 mm height. These were then press extruded through a slit die having a slit opening of about 2.5 mm by 150 mm to produce a ribbon shaped extension which was then calendered one pass in the X direction and cut into 318 mm lengths which were then calendered in the Y direction to produce sheets of about 500 mm length Y direction by about 300 mm in the X direction.

The sheets were then dried and laminated into panels the same as example 1 except that the clamping stress used in the press was about 53 kg/cm²; the temperature was about 388°C and the time at temperature was about 225 minutes.

Data on typical panels prepared by this example are shown in Table 2.

Example 3

A series of formulations were processed to the condition of a wet dough by a procedure similar to that of example 1 except for slight changes in the relative proportions of polymer, filler and fiber as shown in Table 3.

Instead of drying the wet dough before processing it into sheets these formulations were formed into sheets by evenly spreading the wet crum onto a carrier sheet of polyester plastic

film and passing this through the nip of a two roll calender several times to form a self supporting cohesive sheet which was then peeled from the plastic film and subjected to further calender passes until a suitable sheet of desired thickness and size was obtained. This more difficult procedure was necessary because it was found too difficult to extrude the wet dough into a rope or ribbon.

The formed sheets were then dried for sixteen hours at 105 to 204°C in a forced air circulator oven. The dried sheets were assembled with 34 $\mu$m thick copper foil and stainless steel caul plates into laminating packages.

Laminating was accomplished by the following steps:

1. The package was precompressed by subjecting it to a stress of 70 kg/cm² for 1 minute in a press with platens at about 23°C.

2. The package was heated and sheets and foil were bonded together by clamping the package at 17.3 kg/cm² in a press with plates already heated to 388°C. The package was held in this condition for a period of 50 minutes.

3. The package was densified and cooled by rapidly transferring it to a press with platens at about 23°C where it was clamped at 34.7 kg/cm² until the package temperature was below 150°C.

TABLE 1

Panels clad with 34 $\mu$m copper foil

| Panel identification | 1A | 1B |
|---|---|---|
| Thickness, average of 20 values mm | .618 | .612 |
| Uniformity (std. dev. as % of avg.) | 2.45 | 2.57 |
| Specific gravity by immersion of dielectric only | 2.830 | 2.806 |
| Peel strength of oil bond after 20 seconds float in solder at 260°C (average minimum value per 3 mm strip kN/m) | 1.17 | 1.12 |
| Strain relief after etching away foil mm/m | | |
| X direction | −1.89 | −2.13 |
| Y direction | −.53 | −.69 |
| Dielectric constant at X band | | |
| Resonator in X direction | 10.26 | 10.22 |
| Resonator in Y direction | 10.15 | 10.03 |
| Q of resonator at X band | | |
| As is condition of dielectric | 204 | 192 |
| Dielectric soaked 48 hours in 50°C water | 172 | 154 |
| Water absorption, % weight gain of dielectric specimen after 48 hours in 50°C water | 0.25 | 0.23 |

TABLE 2

| Panel identification | 2A | 2B | 2C |
|---|---|---|---|
| Strain relief mm/m | | | |
| X direction | −1.10 | −.97 | −1.05 |
| Y direction | −1.27 | −1.05 | −1.25 |
| Peel strength, kN/m after 20 sec. float in 260°C solder | 9.4 | 8.2 | 6.8 |
| std. deviation of 4 readings | .6 | .3 | .0 |
| Dielectric constant at 10 GHz | 10.43 | 10.60 | 10.58 |
| Q of resonator | 313 | 283 | 304 |

TABLE 3

| Panel identification | 3A | 3B | 3C | 3D | 3E | 3F | 3G | 3H |
|---|---|---|---|---|---|---|---|---|
| Composition in parts by weight | | | | | | | | |
| Polymer | 33.6 | 33.6 | 33.6 | 33.6 | 31.6 | 31.6 | 31.6 | 31.6 |
| Filler | 63 | 63 | 63 | 63 | 65 | 65 | 65 | 65 |
| Fiber | 3.4 | 3.4 | 3.4 | 3.4 | 3.4 | 3.4 | 3.4 | 3.4 |
| Fiber crush method | press | press | roll | roll | press | press | roll | roll |
| Test results of laminated panels | | | | | | | | |
| 1. Avg. Thickness, mm | .74 | .72 | .75 | .68 | .69 | .71 | .73 | .72 |
| 2. Thickness uniformity (std. dev. as % of avg.) | 2.11 | 1.31 | 1.42 | 3.04 | 1.27 | 1.14 | 1.10 | 1.59 |
| 3. Specific gravity by immersion | 2.904 | 2.936 | 2.936 | 2.905 | 2.966 | 2.941 | 2.900 | 2.945 |
| 4. Dielectric constant at X band | 10.07 | 10.16 | 9.62 | 9.58 | 10.88 | 10.84 | 9.00 | 9.88 |
| 5. Q of resonator at X band | 189 | 183 | 176 | 173 | 178 | 165 | 190 | 176 |

**Claims**

1. A dielectric material having a dielectric constant of at least 9, comprising:

— a fluorinated polymer binder,
— a ceramic filler in particulate form and
— non-conductive inorganic microfibers having an average diameter of between 0,1 and 1 μ and an average length of less than 3 mm, the amount of said microfibers being less than 10% by weight of the dielectric material.

2. A material as claimed in claim 1 or 2, characterized in that the ceramic filler is titanium dioxide.

3. A material as claimed in any one of the claims 1 to 3, characterized in that the microfibers are selected from the group comprising microfibrous glass, fibrous aluminum silicate, fibrous microcrystalline materials, quartz fibers, and zirconia fibers.

4. A method of making a dielectric material comprising the steps of:

— mixing a dispersion of fluorinated polymer particles with a ceramic filler in particulate form, and inorganic microfibers having an average diameter of between 0,1 and 1 μ and an average length of less than 3 mm, to form a slurry, the amount of said microfibers being less than 10% by weight of the dielectric material,
— agglomerating the polymer particles, the ceramic particles and the microfibers to provide a mass, and
— shaping said mass to form a dielectric material.

5. A method as claimed in claim 4, characterized by the addition of a floculant to the slurry of polymer filler and fiber.

6. A method as claimed in claim 4 or 5, characterized by the addition of a lubricant to the mass to provide for shaping of the mass.

7. A circuit board comprising a sheet of dielectric material, in accordance with any one of the claims 1 to 3 and a sheet of conductive foil adhered to each of the surfaces of the sheet of dielectric material.

8. A circuit board according to claim 7, wherein the conductive foil comprises copper.

9. A circuit board according to claim 7 or 8, wherein said circuit board has a dielectric constant between about 10 and about 11.

10. A circuit board according to claim 7 or 9, wherein the filler comprises between about 10 and about 65 weight percent of the dielectric material.

11. A method of making a circuit board as claimed in claim 7 comprising mixing the particulate filler material and microfibrous material and polymer dispersion to form a slurry of polymer, filler and fiber, agglomerating the polymer, the filler particles and the microfibers to provide a mass, forming the mass into a sheet, and adhering conductive foil to each side of the sheet to provide a circuit board.

12. A method according to claim 11, wherein said conductive foil comprises copper foil.

**Revendications**

1. Matière diélectrique ayant une constante diélectrique d'au moins 9, comprenant

— un liant de polymère fluoré,
— une charge céramique en particules, et
— des microfibres inorganiques non conductrices ayant un diamètre moyen se situant entre 0,1 et 1 μ et une longueur moyenne inférieure à 3 mm, la quantité de ces microfibres étant inférieure à 10%, calculé sur le poids de la matière diélectrique.

2. Matière suivant la revendication 1, caractérisée en ce que la charge céramique est du dioxyde de titane.

3. Matière suivant l'une quelconque des revendications 1 ou 2, caractérisée en ce que les microfibres sont choisies parmi le groupe comprenant le verre microfibreux, le silicate d'aluminium fibreux, les matières microcristallines fibreuses, les fibres de quartz et les fibres de zircone.

4. Procédé de fabrication d'une matière diélectrique, ce procédé comprenant les étapes qui consistent à:

— mélanger une dispersion de particules de polymère fluoré avec une charge céramique en particules, ainsi que des microfibres inorganiques ayant un diamètre moyen compris entre 0,1 et 1 μ et une longueur moyenne inférieure à 3 mm, en vue de former une bouillie, la quantité de ces microfibres étant inférieure à 10%, calculé sur le poids de la matière diélectrique,
— agglomérer les particules de polymère, les particules céramiques et les microfibres pour former une masse, et
— façonner cette masse en vue de former une matière diélectrique.

5. Procédé suivant la revendication 4, caractérisé en ce qu'un agent floculant est ajouté à la bouillie du polymère, de la charge et des fibres.

6. Procédé suivant la revendication 4 ou 5, caractérisé en ce qu'un lubrifiant est ajouté à la masse pour permettre le façonnage de cette dernière.

7. Plaquette à circuits comprenant une feuille d'une matière diélectrique suivant l'une quelconque des revendications 1 à 3, ainsi qu'une feuille conductrice adhérant à chacune des surfaces de la feuille de matière diélectrique.

8. Plaquette à circuits suivant la revendication 7, caractérisée en ce que la feuille conductrice est constituée de cuivre.

9. Plaquette à circuits suivant la revendication 7 ou 8, caractérisée en ce qu'elle a une constante diélectrique se situant entre environ 10 et environ 11.

10. Plaquette à circuits suivant la revendication 7 ou 9, caractérisée en ce que la charge constitue environ 10 à environ 65% en poids de la matière diélectrique.

11. Procédé de fabrication d'une plaquette à circuits suivant la revendication 7, ce procédé consistant à mélanger la charge en particules, la matière microfibreuse et la dispersion de polymère en vue de former une bouillie du polymère, de la charge et des fibres, agglomérer le polymère, les particules de charge et les microfibres en une masse, transformer cette masse en une feuille, puis faire adhérer une feuille conductrice à chaque face de cette feuille en vue de réaliser une plaquette à circuits.

12. Procédé suivant la revendication 11, caractérisé en ce que la feuille conductrice est une feuille de cuivre.

**Patentansprüche**

1. Dielektrischer Werkstoff mit einer Dielektrizitätskonstanten von mindestens 9, enthaltend

ein fluoriertes Polymer-Bindemittel, einen keramischen Füllstoff in Partikelform und
nichtleitende anorganische Mikrofasern mit einem durchschnittlichen Durchmesser zwischen 0,1 und 1 $\mu$ und einer durchschnittlichen Länge von weniger als 3 mm,

wobei die Menge der Mikrofasern geringer als zehn Gewichtsprozent des dielektrischen Werkstoffes ausmacht.

2. Werkstoff nach Anspruch 1, dadurch gekennzeichnet, daßder keramische Füllstoff Titandioxid ist.

3. Werkstoff nach Anspruch 1 oder 2, dadurch gekennzeichnet, daß die Mikrofasern aus einer Materialgruppe ausgewählt sind, welche Glas-Mikrofasern, Aluminiumsilikat in Faserform, mikrokristalline Werkstoffe in Faserform, Quarzfasern und Zirkoniumdioxidfasern enthält.

4. Verfahren zur Herstellung eines dielektrischen Werkstoffes mit den folgenden Verfahrensschritten:

Mischen einer Dispersion aus fluorierten Polymerpartikeln mit einem keramischen Füllstoff in Partikelform und anorganischen Mikrofasern, welche einen durchschnittlichen Durchmesser zwischen 0,1 und 1 $\mu$ und eine durchschnittliche Länge von weniger als 3 mm haben, um eine Aufschwemmung zu erhalten, wobei die Menge der Mikrofasern weniger als zehn Gewichtsprozent des dielektrischen Materials ausmächen,
Bilden eines Agglomerates der Polymerpartikel, der keramischen Partikel und der Mikrofasern zur Erzeugung einer Masse und
Formen der Masse zur Bildung eines dielektrischen Körpers.

5. Verfahren nach Anspruch 4, gekennzeichnet durch die Zugabe eines Ausflockungsmittel zu der Aufschwemmung aus den Polymerpartikeln, den Füllstoffpartikeln und den Mikrofasern.

6. Verfahren nach Anspruch 4 oder 5, gekennzeichnet durch die Zugabe eines Gleitmittels zu der gebildeten Masse für deren Verformung.

7. Schaltungsplatte mit einer Lage aus dielektrischem Werkstoff gemäß einem der Ansprüche 1 bis 3 und je einer Bahn aus leitender Folie, welche jeweils an je einer Oberfläche der Lage aus dielektrischem Werkstoff haftet.

8. Schaltungsplatte nach Anspruch 7, bei welcher die leitende Folie Kupfer enthält.

9. Schaltungsplatte nach Anspruch 7 oder 8, welche eine Dielektrizitätskonstante zwischen etwa 10 und etwa 11 aufweist.

10. Schaltungsplatte nach einem der Ansprüche 7 bis 9, bei welcher der Füllstoff zwischen etwa 10 und etwa 65 Gewichtsprozent des dielektrischen Werkstoffs ausmacht.

11. Verfahren zur Herstellung einer Schaltungsplatte gemäß Anspruch 7, mit den Verfahrensschritten des Mischens des in Partikelform vorliegenden Füllstoffs und der Mikrofasern sowie einer Polymerdispersion zur Bildung einer Aufschwemmung des Polymerstoffes, des Füllstoffes und der Fasern, ferner der Bildung eines Agglomerates des Polymerstoffes, des Füllstoffes in Partikelform und der Mikrofasern zur Erzeugung einer Masse, weiter der Formung der Masse in eine Bahn und der festen Anbringung leitender Folien auf jeder Seite der Bahn zur Erzeugung der Schaltungsplatte.

12. Verfahren nach Anspruch 11, bei welchem als leitfähige Folie eine Kupferfolie dient.